Europäisches Patentamt

European Patent Office

Office européen des brevets

(19)

(11) Numéro de publication : **0 431 999 B1**

(12) **FASCICULE DE BREVET EUROPEEN**

(45) Date de publication du fascicule du brevet :
30.03.94 Bulletin 94/13

(51) Int. Cl.⁵ : **C23C 18/12, C04B 41/50**

(21) Numéro de dépôt : **90403248.9**

(22) Date de dépôt : **16.11.90**

(54) **Procédé de dépôt d'une composition céramique en couche mince, et produit obtenu par ce procédé.**

(30) Priorité : **20.11.89 FR 8915174**

(43) Date de publication de la demande :
**12.06.91 Bulletin 91/24**

(45) Mention de la délivrance du brevet :
**30.03.94 Bulletin 94/13**

(84) Etats contractants désignés :
**DE GB**

(56) Documents cités :
**US-A- 4 485 094**
**PROCEEDINGS OF THE 6. IEEE INTERNA-**
**TIONAL SYMPOSIUM ON APPLICATIONS**
**OFFERROELECTRICS, 8-11 juin 1986, pages**
**374-380, Lehigh University,Bethlehem, PA, US;**
**R.W. VEST et al.: "PbTiO3 Films from Metal-**
**lo-organicPrecursors"**
**PATENT ABSTRACTS OF JAPAN, vol. 13, no.**
**63 (C-568)(3411), 13 février 1989; & JP-A-63 255**
**375**

(73) Titulaire : **THOMSON-CSF**
**173, Boulevard Haussmann**
**F-75008 Paris (FR)**

(72) Inventeur : **Valente, Isabelle**
**THOMSON-CSF SCPI Cédex 67**
**F-92045 Paris la Défense (FR)**
Inventeur : **Faure, Sylvain**
**THOMSON-CSF SCPI Cédex 67**
**F-92045 Paris la Défense (FR)**
Inventeur : **Gaucher, Philippe**
**THOMSON-CSF SCPI Cédex 67**
**F-92045 Paris la Défense (FR)**
Inventeur : **Livage, Jacques**
**THOMSON-CSF SCPI Cédex 67**
**F-92045 Paris la Défense (FR)**

(74) Mandataire : **Guérin, Michel et al**
**THOMSON-CSF SCPI B.P. 329 50, rue**
**Jean-Pierre Timbaud**
**F-92402 Courbevoie Cédex (FR)**

Il est rappelé que : Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

L'invention concerne un procédé de dépôt d'une composition céramique en couche mince et le produit obtenu par ce procédé. Elle a été conçue en collaboration entre le laboratoire Céramiques du Laboratoire Central de Recherches de THOMSON-CSF d'une part et le laboratoire de Physique de la Matière Condensée de l'Université de PARIS VI (CNRS) dirigé par le Pr. Jacques LIVAGE d'autre part.

Un grand nombre de céramique d'oxydes ont des applications potentielles dans le domaine de la microélectronique. Il s'agit par exemple de pérovskites à applications diélectriques telles que les ferroélectriques $PbTi_xZr_{1-x}O_3$ ou bien des matériaux à propriétés conductrices et transparentes tels que les oxydes d'$In_xSn_{1-x}O$ ou encore des supraconducteurs à base de cuivre et d'oxydes d'éléments tels que (Y, Ba), (Bi, Sr, Ca) ou (Ti, Ba, Ca).

Ces composés doivent être déposés en couche mince sur des substrats tels que l'alumine, le silicium ou la silice $SiO_2$ sur lesquels peuvent avoir été préalablement déposées des couches tampons telles que d'autres d'oxydes ou des métaux nobles dont le but est soit de servir de contact électrique (ou d'isolant) soit d'assurer une meilleure adhérence du film céramique sur le substrat.

Une technique courante de dépôt de films céramiques est la sérigraphie où les poudres d'oxydes, préalablement réagies, sont mélangées à un liant et appliquées sur le substrat. Il s'agit alors de chauffer pour éliminer le liant organique et obtenir un frittage des grains de poudre entre eux qui assurera une meilleure densité de la céramique, des meilleures propriétés électroniques et éventuellement des propriétés optiques telles que la transparence.

La reproductibilité et la fiabilité des propriétés de films ainsi déposés sont liées à leur microstructure et au traitement thermique imposés aux films.

La nécessité d'intégration dans des systèmes de plus en plus réduits impose des poudres de départ submicroniques pour obtenir une faible rugosité. Ceci est cependant difficilement obtenu par les méthodes de synthèse classique à base de mélange de poudres sèches. De plus, l'anisotropie éventuelle des propriétés liée A une anisotropie de la structure cristalline du matériau lui-même peut requérir une texturation de la céramique en alignant les grains parallèlement au substrat. Ceci peut être réalisé par la cristallisation directe des phases orientées par le substrat.

La cristallisation de la phase souhaitée ainsi que sa densification se font de façon conventionnelle à des températures proches de la température de fusion des matériaux afin d'assurer une mobilité aisée des cations. Malheureusement, dans le cas de dépôt sur un substrat cela provoquera également des réactions avec celui-ci ou avec d'autres couches dans le cas de procédés multicouches. De plus, la différence de coefficients de dilatation des différents éléments provoquera du faïençage à haute température. Il est donc nécessaire de trouver des procédés favorisant une température de synthèse basse. Une autre raison peut être la volatilité de certains éléments (Pb, Bi) à haute température.

Une possibilité de faible coût pour le dépôt de films est la synthèse à partir de solutions où le mélange homogène des éléments permet de s'affranchir du problème de la barrière de diffusion ionique et d'abaisser ainsi la température de synthèse. La difficulté est alors d'obtenir des solutions dont les propriétés rhéologiques permettent un dépôt de films homogènes avant le traitement thermique.

Des précurseurs intéressants de ces synthèses en solution sont les alkoxydes (procédés sol-gel). Leur hydrolyse mène à la condensation de réseaux polymériques d'oxydes et d'hydroxydes précurseurs des phases souhaitées. Néanmoins, il est parfois peu évident de contrôler le taux d'hydrolyse lorsqu'il s'agit de la synthèse de phases complexes contenant un grand nombre d'éléments aux propriétés différentes. On peut difficilement contrôler à la fois l'homogénéité chimique qui permettra l'abaissement de la température de synthèse et la rhéologie souhaitable pour le dépôt. D'autre part, la manipulation des alkoxydes n'est pas toujours aisée.

On peut alors partir de solutions ioniques dont la viscosité et l'élasticité ont été modifiées par la présence d'agents modificateurs ajoutés aux solvants (glycol, glycérol, acide citrique) tels que des poly-alcools, des poly-acides conduisant à des résines polymères. Cependant, tous ces additifs ne sont pas forcément compatibles avec les cations. Il faut également une solution qui adhère bien au substrat pendant le dépôt. C'est un procédé compliqué et la substance obtenue se dépose très difficilement par la méthode dite "à la tournette".

Afin de pallier ces inconvénients, la présente invention porte sur un procédé de dépôt d'une composition céramique en couche mince à partir d'une solution homogène dont la rhéologie peut être adaptée au dépôt à la tournette (encore appelé "wafer spinning" dans la terminologie anglo-saxonne) de systèmes multicomposants. Les cations sont solubilisés dans une solution où une polymérisation (ou maturation) est provoquée par la réaction de 2 composés organiques : l'acétylacétone (ACAC) et l'hexaméthylènetétramine (HMTA).

L'invention a donc pour objet un procédé de dépôt d'une composition céramique en couche mince sur un substrat, caractérisé en ce qu'il comporte les étapes suivantes :

- dissolution des constituants de base de la composition céramique, introduits sous forme simple ou complexée, dans un solvant,

- ajout à la solution obtenue précédemment d'acétylacétone et d'hexaméthylènetétramine dans des proportions appropriées à la méthode de dépôt choisie,
- maturation ou polymérisation de la substance obtenue à l'étape précédente,
- dépôt sous forme de couche de la substance sur le substrat,
- éventuellement séchage de la couche déposée si plusieurs dépôts sont nécessaires,
- frittage à une température d'environ 700-750°C de la couche ou des couches déposées.

L'invention sera mieux comprise et d'autres avantages apparaîtront à la lecture de la description qui va suivre, donnée à titre non limitatif, et grâce aux dessins annexés parmi lesquels :

- la figure 1 représente un diagramme donnant la perte de masse d'une substance selon l'invention, ainsi que sa dérivée, en fonction de la température,
- la figure 2 représente un cycle d'hystérésis,
- la figure 3 est un diagramme montrant la variation de capacité d'une composition céramique déposée sur silicium selon l'invention en fonction de la tension.

Les deux composés (ACAC et HMTA) utilisés par le procédé selon l'invention sont ajoutés de préférence dans le rapport molaire optimal de 2 moles d'ACAC pour 1 mole de HMTA. En milieu acide ces composés réagissent pour donner une espèce polymérique. Comme de plus ils forment de très bons agents complexants (en particulier l'acétylacétone) indépendamment de la nature des cations, ils maintiennent ces cations solubilisés dans le milieu polymérique quand il se forme et pendant le séchage sur le substrat de dépôt.

Le procédé selon l'invention présente un double intérêt. Il permet d'abord une adaptation aisée à un grand nombre de systèmes différents et on peut donc associer en solution dans une même synthèse des éléments dont le comportement chimique est très différent. Il permet ensuite une adaptation aisée de la rhéologie. Une fois la synthèse obtenue, un polymère est formé qui chélate les cations et dont la concentration détermine la viscosité. La substance obtenue est visqueuse et mouillante. On peut alors par simple élimination du solvant modifier celle-ci. Elle n'évolue pas au cours du temps et ceci permet le stockage de solution de dépôt et un contrôle rigoureux de son adaptation au mode de dépôt choisi.

A titre d'exemple, on va décrire maintenant la synthèse du titanate de plomb $PbTiO_3$.

On dissout dans 50 ml d'acide acétique 8,5 g de tétrabutoxyde de titane $Ti(OBut)_4$ et 9,2 g d'acétate de plomb. On ajoute ensuite 10 ml d'acétylacétone et 4 g d'hexaméthylènetétramine. La solution jaune au départ rougit et devient visqueuse pour arriver à un régime stable au bout de quelques heures. Sa viscosité peut alors être ajustée en évaporant l'acide acétique.

La substance obtenue peut être utilisée telle qu'elle pour un dépôt à la tournette (conditions de dépôt : 20 secondes, 2000 tours à la minute) sur des substrats tels que le corindon et le silicium préalablement recouverts de platine (par dépôt sous vide) pour assurer une bonne conduction électrique.

Selon l'épaisseur de la couche totale à déposer il peut être nécessaire d'effectuer le dépôt en plusieurs fois et donc de sécher chaque couche déposée avant d'en déposer une nouvelle. Le séchage peut se faire à 300°C dans une étuve.

Une fois obtenue l'épaisseur de couche désirée, la couche est frittée à une température d'environ 700-750°C, ce qui n'altère pas le substrat sur lequel la couche est déposée.

Une analyse thermogravimétrique et de calorimétrie différentielle effectuée sur le titanate de plomb ainsi déposé montre qu'un intérêt de la méthode est la douce et régulière perte de masse de la substance lorsque sa température augmente.

Outre l'acide acétique, on peut utiliser comme solvant le propanol ou le méthoxyéthanol.

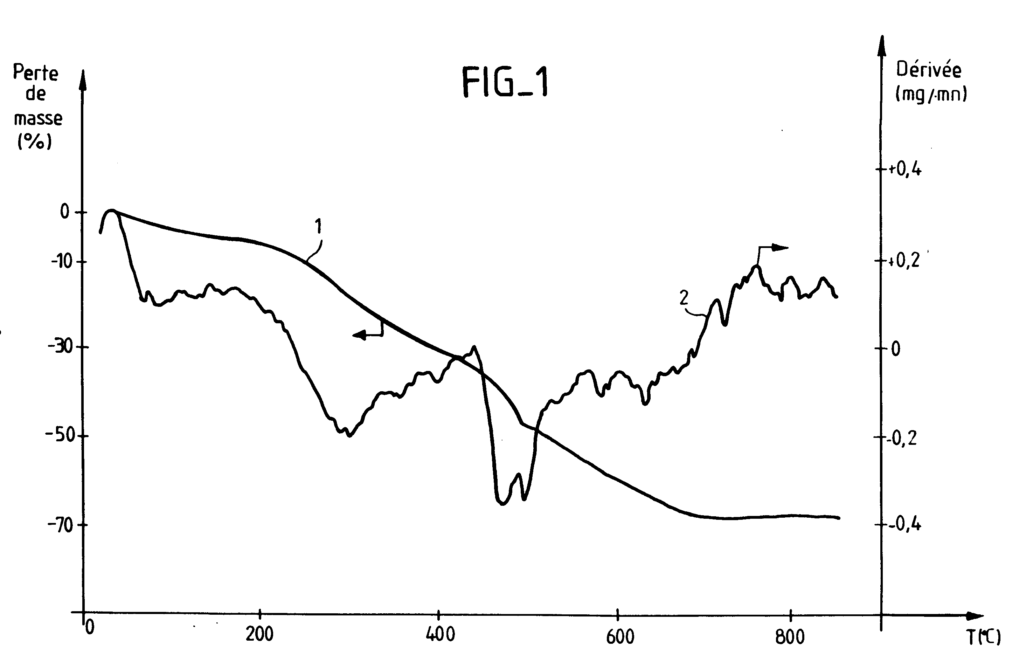

La figure 1 représente un diagramme donnant, en fonction de la température, la courbe de perte de masse (courbe 1 correspondant à l'axe des ordonnées de gauche) et sa courbe dérivée (courbe 2 correspondant à l'axe des ordonnées de droite). On constate qu'effectivement la perte de masse est douce et régulière avec la température. Ceci montre un intérêt de la méthode qui est de ne pas provoquer une oxydation trop violente de la partie organique qui provoquerait un faïencage du film. Les phénomènes exothermiques s'achèvent à 700°C, température à laquelle la phase est cristallisée.

L'épaisseur des couches obtenues peut varier entre 0,2 et 5 $\mu$m par couche. On obtient donc directement des dépôts plus épais que par les méthodes sol-gel connues mais on peut aussi obtenir des dépôts très minces en raison de l'excellent état de surface de la couche.

Les caractéristiques électriques des couches déposées sur platine (électrode déposée par pulvérisation cathodique sur un substrat de silicium orienté 100) et directement sur silicium dopé (de résistivité inférieure à 0,01 $\Omega$ . cm) sont données dans le tableau 1 placé en fin de description. Les mesures électriques sont réalisées sur des plots de métallisation en argent déposés sur la surface de la couche et de surface 7mm$^2$. Dans ce tableau, on a mentionné la capacité C mesurée, les pertes tg$\delta$, la résistance d'isolement Ri, la tension de claquage $V_C$ en volts (pour une couche de céramique d'épaisseur d'environ 1 $\mu$m), la tension correspondant au champ coercitif $V_{coerc}$ et la rémanence R de la polarisation (pour la structure métal-isolant-métal sur platine) et de la capacité (pour la structure métal-isolant-semiconducteur sur silicium).

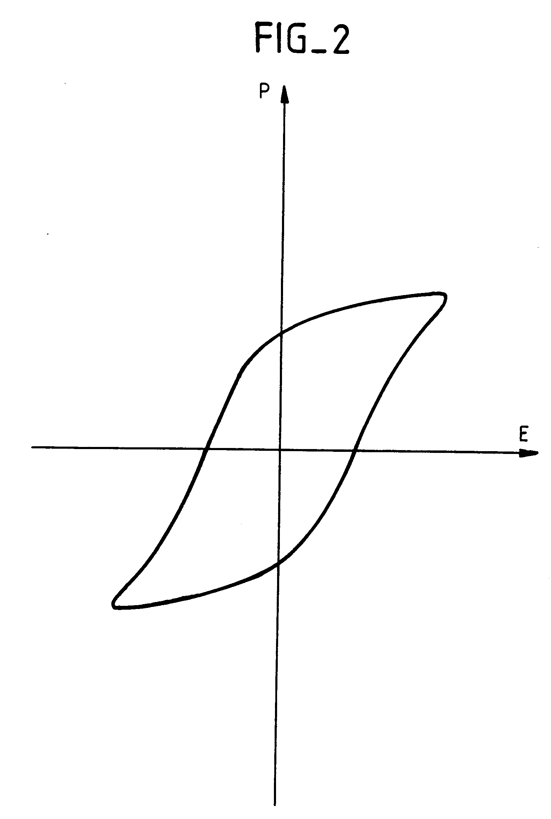

Sur le platine, en raison de la faible valeur des pertes diélectriques (3 %), de la forte valeur de la résistance d'isolement (100 MΩ) et de la tension de claquage (40 V), on a pu réaliser des cycles d'hystérésis à 60 Hz par la méthode de Sawyer et Tower. L'un de ces cycles est représenté à la figure 2 où l'axe des ordonnées représente la polarisation P et l'axe des abscisses le champ électrique E appliqué. La tension coercitive est au plus égale à 16 V et la polarisation rémanente est au moins égale à 4,3 μC/cm².

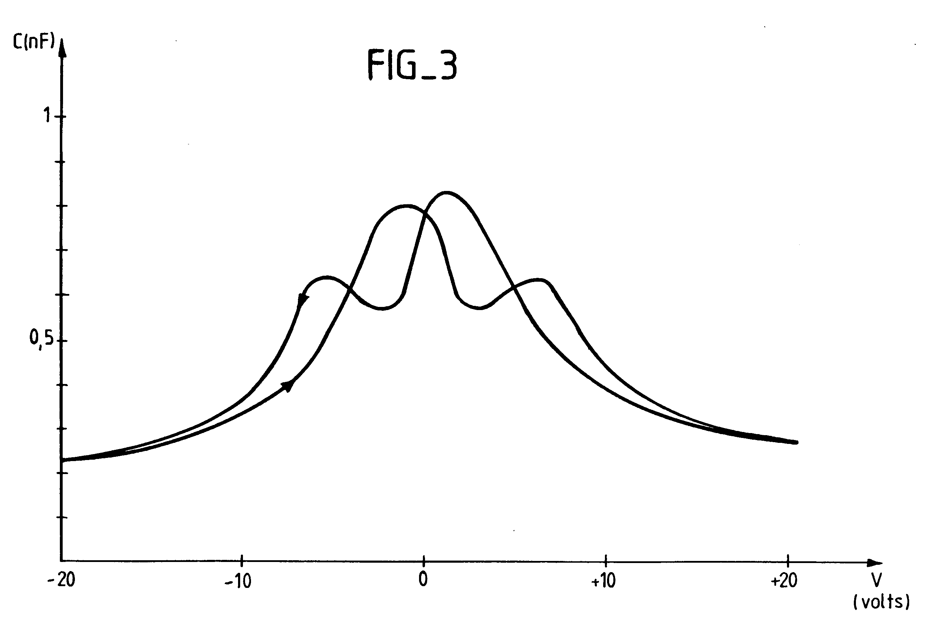

Sur le silicium dopé, la valeur de la capacité est un peu plus faible, probablement en raison d'une capacité série causée dans le semiconducteur par des états d'interface. Sur cette structure métal-isolant-semiconducteur (MIS) on a pu cependant observer un effet de mémoire de la capacité. La figure 3 est un diagramme montrant la capacité C en fonction de la tension V. On remarque que la courbe capacité-tension est dissymétrique pour des tensions croissantes et décroissantes entre -20 volts et + 20 volts. A la courbe normale décroissante de la structure MIS se superpose des pics vers + ou - 6 volts dus au basculement des domaines ferroélectriques.

En résumé, l'invention permet de créer des couches minces de grandes surfaces, sans défaut, d'épaisseur inférieure au micron sur différents substrats métalliques (ou métallisés), semiconducteurs ou isolants avec un procédé simple, peu coûteux, nécessitant des matières premières courantes et bon marché. Les applications se situent dans le domaine des mémoires non volatiles, de l'optique intégrée, des dispositifs à supraconducteurs, des détecteurs acoustiques ou pyroélectriques.

Les dépôts selon l'invention présentent une très faible rugosité de surface et un très bon état de surface dû à la finesse et à l'homogénéité des grains de la céramique.

| | C (nF) | tg$\delta$ (%) | Ri MΩ | $V_C$ (V) | $V_{coerc}$ (V) | R |
|---|---|---|---|---|---|---|
| Sur platine | 1 | 3 | 100 | 40 | 16 | 0,3μC (4,3μC/cm²) |
| Sur silicium | 0,8 | 9 | 1900 | 40 | 6 | 0,15 nF (2,1 nF/cm²) |

TABLEAU 1

**Revendications**

1. Procédé de dépôt d'une composition céramique en couche mince sur un substrat, caractérisé en ce qu'il comporte les étapes suivantes :
   - dissolution des constituants de base de la composition céramique, introduits sous forme simple ou complexée, dans un solvant,
   - ajout à la solution obtenue précédemment d'acétylacétone et d'hexaméthylènetétramine dans des proportions appropriées à la méthode de dépôt choisie,
   - maturation ou polymérisation de la substance obtenue à l'étape précédente,
   - dépôt sous forme de couche de la substance sur le substrat,
   - éventuellement séchage de la couche déposée si plusieurs dépôts sont nécessaires,
   - frittage à une température d'environ 700-750°C de la couche ou des couches déposées.

2. Procédé de dépôt selon la revendication 1, caractérisé en ce que les proportions d'acétylacétone et d'hexaméthylènetétramine sont de 2 moles d'acétylacétone pour 1 mole d'hexaméthylènetétramine.

3. Procédé de dépôt selon l'une des revendications 1 ou 2, caractérisé en ce que le solvant est de l'acide acétique, du propanol ou du méthoxyéthanol.

4. Procédé selon l'une des revendications 1 ou 2, caractérisé en ce que la composition céramique étant du titanate de plomb, le titane est introduit sous forme de tétrabutoxyde de titane et le plomb sous forme d'acétate de plomb, le solvant étant de l'acide acétique.

## Patentansprüche

1. Verfahren zum Abscheiden einer keramischen Verbindung in dünner Schicht auf einem Substrat, dadurch gekennzeichnet, daß es die folgenden Verfahrensschritte enthält:
   - die Grundbestandteile der keramischen Verbindung, die in einfacher oder komplexer Form zugegeben werden, werden in einem Lösungsmittel gelöst;
   - der erhaltenen Lösung werden Azetylazeton und Hexamethylentetramin in der gewünschten Abscheidemethode geeigneten Anteilen zugefügt;
   - man läßt die im vorhergehenden Verfahrensschritt erhaltene Substanz reifen oder polymerisieren;
   - man bringt die Substanz in Form einer Schicht auf das Substrat;
   - gegebenenfalls trocknet man die aufgebrachte Schicht, wenn mehrere Schichten erforderlich sind;
   - man sintert die aufgebrachte Schicht oder die aufgebrachten Schichten bei einer Temperatur von etwa 700 bis 750°C.

2. Verfahren nach Anspruch 1, dadurch gekennzeichnet, daß die Anteile von Azetylazeton und Hexamethylentetramin sich wie 2 Mol Azetylazeton zu 1 Mol Hexamethylentetramin verhalten.

3. Verfahren nach einem der Ansprüche 1 und 2, dadurch gekennzeichnet, daß als Lösungsmittel Essigsäure, Propanol oder Methoxyäthanol verwendet wird.

4. Verfahren nach einem der Ansprüche 1 oder 2, dadurch gekennzeichnet, daß das Titan, falls die keramische Verbindung Bleititanat ist, in Form von Titantetrabutoxyd und das Blei in Form vom Bleiazetat eingebracht werden, während das Lösungsmittel Essigsäure ist.

## Claims

1. Process for depositing a ceramic composition as a thin layer on a substrate, characterized in that it comprises the following stages:
   - dissolving the base constituents of the ceramic composition, which are introduced in simple or complex form, in a solvent,
   - adding acetylacetone and hexamethylenetetramine to the solution obtained previously, in proportions which are appropriate to the chosen deposition method,
   - maturing or polymerizing the substance obtained in the preceding stage,
   - depositing the substance in layer form on the substrate,
   - optionally drying the deposited layer if a number of depositions are necessary,
   - sintering the deposited layer or layers at a temperature of approximately 700-750°C.

2. Deposition process according to Claim 1, characterized in that the proportions of acetylacetone and hexamethylenetetramine are 2 moles of acetylacetone per 1 mole of hexamethylenetetramine.

3. Deposition process according to either of Claims 1 and 2, characterized in that the solvent is acetic acid, propanol or methoxyethanol.

4. Process according to either of Claims 1 and 2, characterized in that, when the ceramic composition is lead titanate, the titanium is introduced in the form of titanium tetrabutoxide and the lead in the form of lead acetate, the solvent being acetic acid.

FIG_1

Perte de masse (%)

Dérivée (mg/·mn)

EP 0 431 999 B1

# FIG_2

FIG_3

C(nF)

1

0,5

-20      -10       0       +10      +20    V
(volts)